# EUROPEAN PATENT SPECIFICATION

(11) **EP 0 211 634 B1**
(45) Date of publication and mention of the grant of the patent: **23.03.1994**
(21) Application number: 86305952.3
(22) Date of filing: 01.08.1986
(51) Int. Cl.: H01L 31/18, H01L 21/324

(54) **Method and apparatus for manufacturing semiconductor devices**
Verfahren und Gerät zur Herstellung von Halbleitervorrichtungen
Procédé et appareil pour la fabrication de dispositifs semi-conducteurs

(30) Priority: 02.08.1985 JP 170956/85; 23.08.1985 JP 186372/85
(43) Date of publication of application: 25.02.1987
(73) Proprietor: SEL SEMICONDUCTOR ENERGY LABORATORY CO., LTD., Atsugi-shi Kanagawa-ken 243 (JP)
(72) Inventor: Yamazaki, Shunpei, Setagaya-Ku Tokyo (JP); Suzuki, Kunio, Atsugi-Shi Kanagawa-Ken (JP); Nagayama, Susumu, Setagaya-Ku Tokyo (JP); Inujima, Takashi, Atsugi-Shi Kanagawa-Ken (JP); Abe, Masayoshi, Tama-Shi Tokyo (JP); Fukada, Takeshi, Ebina-Shi Kanagwa-Ken (JP); Kinka, Mikio, Atsugi-Shi Kanagawa-Ken (JP); Kobayashi, Ippei, Atsugi-Shi Kanagawa-Ken (JP); Shibata, Katsuhiko, Atsugi-Shi Kanagawa-Ken (JP); Susukida, Masato, Atsugi-Shi Kanagawa-Ken (JP); Koyanagi, Kaoru, Iwamurata Saku-Shi Nagano-Ken (JP)
(74) Representative: Milhench, Howard Leslie

(56) References cited:
- EP-A- 0 139 409
- US-A- 4 226 898
- US-A- 4 371 738
- PHYSICAL REVIEW, B. Condensed Matter, vol. 27, no. 6, March 1983, American Physical Society, New York, US; K.P. CHIK et al.: "Photoconductivity of evaporated amorphous silicon films post-hydrogenated in a theta-pinch plasma"

## Description

This invention relates to an improved method and apparatus for manufacturing semiconductor devices which has particular application to photoelectric conversion devices.

Processing techniques are known for the fabrication of semiconductor devices comprising a substrate and a non-monocrystalline semiconductor layer formed on the substrate. In many products manufactured according to such techniques, some undesirable effects have been observed. In particular, it has been found that immediately after fabrication, a highly purified semiconductor exhibits a decrease in electric conductivity under photo annealing in atmospheric air and that its conductivity can recover under thermal annealing. The effect appears repeatedly. We have found that this phenomenon, known as the Staebler-Wronski effect, is observed only on semiconductors taken out of a vacuum chamber and brought into contact with the atmosphere. Not only does the Staebler-Wronski effect cause a cyclical change in the electrical conductivity of a semiconductor device but also the conductivity tends to gradually decrease with repetition of the Staebler-Wronski effect. This is clearly undesirable, especially in semiconductors to be applied to solar cells, and like photoelectric conversion devices.

It would therefore be desirable to produce improved semiconductors which are thermally and optically more stable than the semiconductors produced hitherto.

Published European Patent Application EP-A1-0139409 describes a method of forming amorphous alloys by neutralising defect states such as dangling bonds, neutralisation being achieved by addition of fluorine to the amorphous alloy in an ultra high vacuum environment. This reference, however, is concerned merely with neutralising already-existing dangling bonds.

In accordance with the present invention there is provided a process for the fabrication of non-monocrystalline semiconductor material wherein the just-formed material is photoirradiated thereby to develop dangling bonds and subsequently the dangling bonds are stabilized by combination with a neutralizing agent.

The present invention resides in the appreciation that the disadvantageous Staebler-Wronski effect arises on account of the presence of recombination instabilities in the surface microstructure of the semiconductor and that these instabilities can be largely eradicated if the semiconductor is fabricated in a manner which encourages the development of dangling bonds on its surface and if stable bondings are then made to the dangling bonds.

Thus in accordance with an exemplary embodiment of the invention in which a semiconductor layer is formed by a plasma CVD method, the thus formed layer is irradiated within an evacuated chamber before it is exposed to atmospheric air so as to encourage the formation of dangling bonds and a gaseous neutralizing agent is then admitted to the chamber so as to stabilize the dangling bonds. The resulting semiconductor exhibits substantially increased stability as compared to conventionally fabricated semiconductors exhibiting the Staebler-Wronski effect.

The neutralizing agent employed to stabilize the dangling bonds can be any one or more of fluorine, chlorine, oxygen, nitrogen, argon, krypton, xenon, helium or hydrogen gas, or can be a fluoride, a chloride or an oxide in combination with UV light irradiation to break down the compound into its atomic constituents. The requirement is that the neutralizing agent should be capable of binding to the dangling bonds in stable fashion.

The invention extends not only to a manufacturing process for fabrication of improved semiconductors and to semiconductors fabricated in accordance with such process, but also to an improved fabrication apparatus hereinafter described for carrying out the process according to the invention.

Other features of the invention are set forth with particularity in the appended claims, and the invention and all such features will be well understood from consideration of the following detailed description of exemplary embodiments which is given with reference to the accompanying drawings, wherein:
Fig. 1 is a schematic view of a plasma vapour reactor according to one embodiment of the present invention;
Fig. 2 is a cross sectional view showing a method of measuring the electrical conductivity of a semiconductor layer fabricated according to the embodiment of the invention;
Fig. 3 is a graphical diagram showing the electrical conductivity characteristic of a prior art intrinsic semiconductor; and
Figs. 4, 5, 6, 7 and 8 are graphical diagrams showing electric conductivity characteristics of semiconductors formed by means of a semiconductor manufacturing method and apparatus according to the present invention.

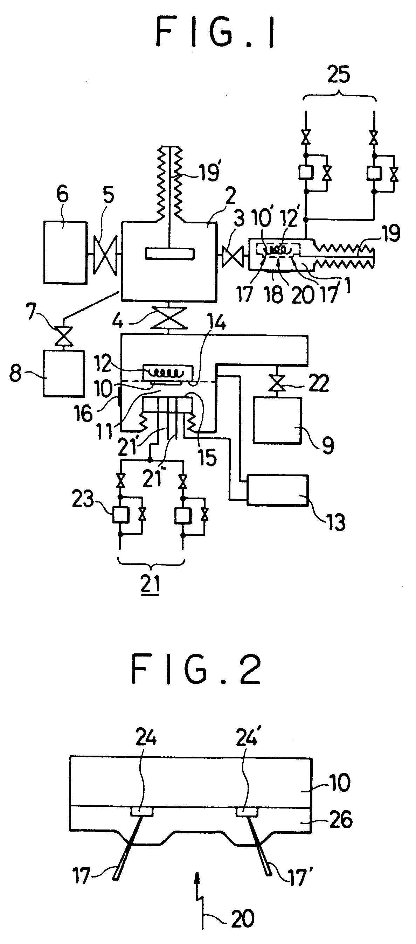

Referring to Fig. 1, an exemplary ultra high vacuum semiconductor fabrication apparatus according to the invention is shown. In the figure, a substrate 10' made of artificial quartz is placed below a heater 12' in a first pre-stage chamber 1. The substrate 10' is provided with a pair of electrodes (designated as 24 and 24' in Fig. 2) for measuring electric conductivity. These electrodes can be contacted with a pair of probes 17 and 17' from outside of the chamber 1 after formation of a semiconductor layer on the substrate so that it is possible to measure the conductivity of the semiconductor in situ in the presence of light and in the absence of light, without the semiconductor making contact with atmospheric air.

The substrate 10' can be transported with the heater 12' between the first chamber 1 and a second pre-stage chamber 2 through the gate valve 3. The second pre-stage chamber 2 is connected to a criosorption pump 6 through a second gate valve 5 and to a turbo molecular pump 8 through a third gate valve 7. After placing the heater 12' on which the substrate 10' is held in the first chamber 1, the turbo molecular pump 8 is driven to evacuate the interiors of the first and second chambers 1 and 2 with the gate valves 3 and 7 opened and the gate valves 5 and 4 closed. When a pressure of 10⁻⁶ torr or less has been attained in the chambers 1 and 2, the heater 12' with the substrate 10' are transported from the first chamber 1 to the second chamber 2 by means of a first transportation mechanism 19. Then the interior of the second chamber 2 is further evacuated to a pressure of the order of 1.3 x 10⁻⁸ Pa (10⁻¹⁰ torr) with the gate valves 3 and 7 closed and the gate valve 5 opened by means of the criosorption pump 6.

The interior of a reaction chamber 11 can be evacuated to a negative pressure of the order of 1.3 x 10⁻⁷ Pa (10⁻⁹ torr) to 1.3 x 10⁻⁸ Pa (10⁻¹⁰ torr) by means of a second criosorption pump 9 which is connected to the reaction chamber 11 through a gate valve 22, and when it has been thus evacuated the substrate 10 on the heater 12 is transported from the second pre-stage chamber 2 and through the open gate valve 4 and into the reaction chamber 11 by means of a second transportation mechanism 19'. Once the substrate 10 and heater 12 are within the reaction chamber 11, the valve 4 is closed and a plasma discharge is established between a pair of electrodes 14 and 15 which are supplied with power from a high frequency voltage supply 13 so as to carry out a plasma CVD method of semiconductor deposition on the substrate 10. Concurrent with the plasma discharge, light irradiation may be carried out by irradiating the interior of the reaction chamber 11 with an eximer laser or the like through a window 16.

It is to be understood that whilst two sets of substrates 10 and 10' and heaters 12 and 12' are shown in Fig. 1, this is only to expedite the explanation and understanding of the embodiment and in practice there is of course only one heater 12 and one substrate 10.

The reactive gas for the plasma CVD method of semiconductor deposition is introduced into reaction chamber 11 from a doping system 21. The pressure of the reaction chamber is kept to the optimum level most suitable for carrying out the CVD semiconductor deposition method by means of the turbo molecular pump 9.

The pressure in the reaction chamber 11 is generally kept between 0.13 Pa (0.001 torr) and 13 Pa (0.1 torr), and is normally between 6.5 Pa (0.05 torr) and 13 Pa (0.1 torr). By virtue of the high frequency energy, e.g. 13.56 MHz at 10 watts, applied from the power supply 13, a non-monocrystalline semiconductor film, an amorphous silicon doped with hydrogen in this embodiment, is formed in accordance with the plasma CVD method. For example, a non-monocrystalline semiconductor layer of thickness 0.6µ which may or may not be doped with p-type or n-type impurities may be formed on the substrate 10 at a temperature of 250^{o}C or less than 500^{o}C.

The reactive gas required for the CVD process and a carrier gas should be purified to the level at which their inclusion rates of oxygen and water are reduced to the order of less than 0.1 ppm, and more preferably to less than 1 ppb, before their introduction to the reaction chamber 11. This is in order to reduce the density of oxygen within the semiconductor to less than 5 x 10¹⁸cm⁻³, and more preferably less than 1 x 10¹⁸cm⁻³. The reactive gas can for example be silane which has been highly purified as by liquefaction purification as for the fabrication of silicon film.

In the case where a photoelectric cell is to be formed, high doping may be required. To make a p-type semiconductor, the silane gas may be dosed with diborane at 500 to 5000 ppm. To make an n-type semiconductor the silane gas may be dosed with phosphine at about 5000 ppm. The impurities are introduced via an inlet port 21''.

Upon completion of the CVD formation of the semiconductor layer 26, the supply of reactive gas is interrupted and the residue thereof is eliminated from the reaction chamber 11 by means of the turbo molecular pump 9.

After evacuating the reaction chamber 11 by means of the turbo molecular pump 9, the substrate 10 on the heater 12 is transported from the reaction chamber 11 to the first prestage chamber 1 via the second pre-stage chamber 2 with the gate valves 3 and 4 opened. Then, with the gate valve 4 closed and the gate valve 5 opened, the pressure in the first prestage chamber 1 is kept at a prescribed negative pressure by means of the criosorption pump 6. This negative pressure may be less than 0.13 Pa (10⁻³ torr), and preferably is between 1.3 x 10⁻⁴ Pa (10⁻⁶ torr) and 1.3 x 10⁻⁷ Pa (10⁻⁹ torr). Within the pre-stage chamber 1, the semiconductor 10 is maintained at a temperature of less than 50^{o}C so that it does not experience thermal annealing, and is irradiated with light without being allowed to make contact with the atmospheric air. By virtue of such light irradiation, dangling bonds are caused to appear on the semiconductor and these are thereafter neutralized by the introduction into the chamber 1 via the dosing system 25 of a neutralizing agent such as fluorine, chlorine, oxygen, nitrogen, argon, krypton, xenon, helium or hydrogen. The fabrication of the semiconductor is then complete.

In the case where fluorine is used as the neutralizing agent, fluorine gas of a purity of 99% or higher is suitable. This can be obtained by liquefaction purification, namely, fluorine (m.p.-223^{o}C, v.p.-187^{o}C) retained in a vessel is liquefied by means of liquefied nitrogen. Then, the liquefied fluorine is vaporized under negative pressure and is recovered as very highly purified fluorine. By virtue of this processing, the fluorine is estimated to have higher than 99.99% purity with very little included oxygen and a dew point lower than -60^{o}C.

Thus introduced, the fluorine permeates into the microstructure of the semiconductor surface and neutralizes the dangling bonds which were caused to appear on the semiconductor surface by the photo annealing. In addition to replacing dangling bonds Si- by means of Si-F bondings, the fluorine also substitutes Si-F bondings for Si-H bondings which have relatively weak bonding forces.

Fig. 2 shows the semiconductor layer 26 on the substrate 10 fabricated as described above. The substrate 10 is made of a synthetic quartz. The semiconductor layer 26 is made of a non-monocrystal amorphous silicon doped with hydrogen or halogen.

The semiconductor layer 26 was subjected to repeated light irradiation annealing and thermal annealing for examining the change in conductivity of the semiconductor layer 26. The photo annealing was carried out using a halogen lamp (100mW/cm²) and the thermal annealing was carried out by supplying power to the heater 12. The conductivity was measured by means of the pair of probes 17 and 17' in contact with the pair of electrodes 24 and 24' and with the semiconductor at a negative pressure.

Before describing the experimental results obtained when the conductivities of semiconductor layers formed in accordance with the present invention were measured, a brief explanation of the prior art will be provided for reference.

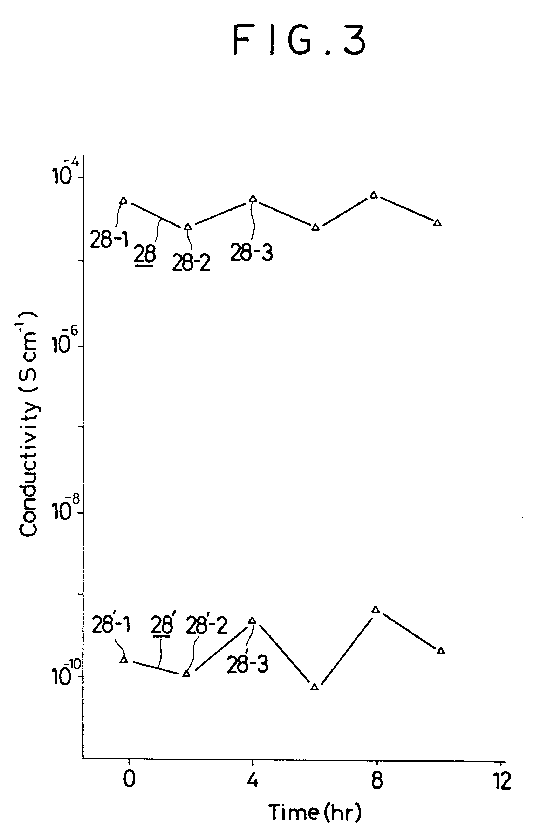

Fig. 3 shows how the conductivity of a conventionally manufactured semiconductor varies under alternate thermal annealing and photo annealing under atmospheric conditions. The conventional semiconductor under consideration comprised a silicon semiconductor layer of 0.6µ thickness formed on a quartz glass plate.

In the following, the conductivity of the semiconductor in the presence of light (from a xenon lamp) is referred to as its photo conductivity and the conductivity in the absence of light is referred to as its dark conductivity.

In Fig. 3, the initial photo conductivity is designated as 28-1, and the initial dark conductivity as 28'-1. The semiconductor layer was then irradiated with light of AM1(100mW/cm²) from a xenon lamp for a determined period and the resulting photo and dark conductivities 28-2 and 28'-2 showed a decrease from their initial levels. Then, thermal annealing was carried out at 150^{o}C for 2 hours, and the resulting conductivities 28-3 and 28'-3 showed an increase from their preceding levels. In this manner, thermal and photo annealing steps were repeated one after another. As a result, the Staebler-Wronski effect was demonstrated as shown in Fig. 3, with both the photo and dark conductivities being repetitively decreased by photo annealing and subsequently increased by thermal annealing.

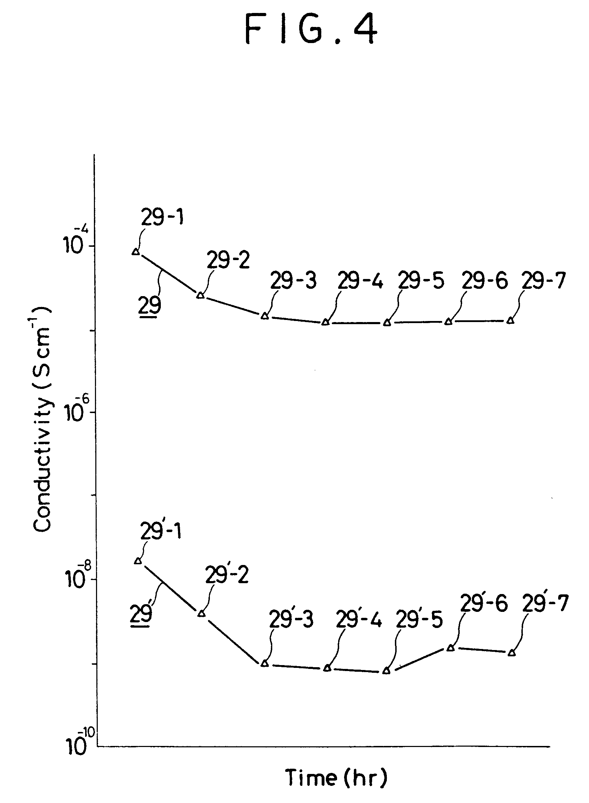

Referring now to Figs. 4 through 8 the variation of the conductivity of a semiconductor layer manufactured in accordance with the present invention is shown with the semiconductor repetitively subjected to optical and thermal annealings carried out alternately as described above. In Fig. 4, the measurement results are designated by 29-1, 29-2,...29-7 and by 29'-1, 29'-2,...29'-7 with the references 1,2,...7 indicating the ordinal number of the corresponding measurement and with the references preceded by 29 indicating a photo conductivity measurement and the references preceded by 29' indicating a dark conductivity measurement, and a similar system of reference numerals is used in the other figures.

Fig. 4 is a graphical showing of the conductivity variations of a semiconductor layer formed in accordance with the present invention but without treatment with the neutralizing agent, the conductivity measurements having been made in the pre-stage chamber 1 under negative pressure and without exposing the semiconductor to contact with air. Initially, a dark conductivity 29'-1 of 1.5 x 10⁻⁸ Scm⁻¹ and a photo conductivity 29-1 of 9 x 10⁻⁵ Scm⁻¹ was obtained at 25^{o}C and 4 x 10⁻⁸ torr. Thereafter the semiconductor layer was subjected to photo annealing for two hours at 100mW/cm² by irradiation with a xenon lamp. A dark conductivity 29'-2 of 6 x 10⁻⁹ Scm⁻¹ and a photo conductivity 29-2 of 3.5 x 10⁻⁵ Scm⁻¹ were obtained indicating decreases from the initial levels as in the prior art. Next, the semiconductor was subjected to thermal annealing for 3 hours at 150^{o}C. Unexpectedly, as a result, the conductivity further decreased unlike the conventional situation. This phenomenon which we have discovered has been named by us as the SEL effect, this terminology being derived from the words "State Exited by Light". The reason why this SEL effect takes place, instead of the Staebler-Wronski effect, is believed to be because dangling bonds formed on the semiconductor remain intact during repeated photo and thermal annealing in the evacuated chamber.

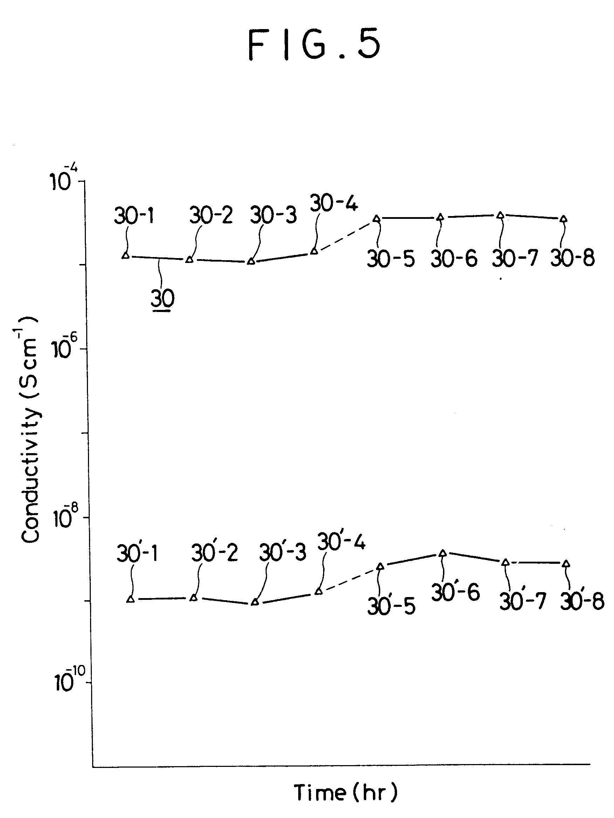

Fig. 5 shows the conductivity of a semiconductor layer measured in situ in the device of Fig. 1 with oxygen introduced at 4 x 10⁴ Pa, that is approximately the same pressure as the partial pressure of oxygen in atmospheric air, into the first pre-stage chamber as a neutralizing agent. The values 30-1 and 30'-1 designate the photo and dark conductivities respectively before the introduction of oxygen, and the values 30-2 and 30'-2 designate the photo and dark conductivities respectively after the introduction of oxygen. After the conductivity measurements 30-2 and 30'-2 were made, the semiconductor was irradiated with light from a halogen lamp at 100 W/cm² for two hours. As a result the measured conductivities 30-3 and 30'-3 were found to remain substantially as they were, although a slight decrease was observed. Next, after thermal annealing for 3 hours at 150^{o}C, the conductivities slightly recovered to 30-4 at 1.3 x 10⁻⁵ Scm⁻¹ and 30'-4 at 1.2 x 10⁻⁹ Scm⁻¹. The semiconductor was then left at negative pressure for a week and its conductivity was measured again and a substantial increase was found. Although the inventors then repeated photo annealing for 2 hours and thermal annealing for 3 hours at 150^{o}C one after another, no appreciable change in the conductivity was subsequently observed as is shown by the values 30-6 of 2.5 x 10⁻⁵; 30'-6 of 3 x 10⁻⁹; 30-7 of 2.7 x 10⁻⁵; and 30'-7 of 2.3 x 10⁻⁹. This trend can be explained by considering that in the manufacturing method of the invention, after a sufficiency of dangling bonds are produced to serve as recombination centers by virtue of the light irradiation of the semiconductor under negative pressure, the dangling bonds are neutralized by introduction of oxygen or another neutralizer so that the recombination centers which impair the stability of the semiconductor are neutralized. Once neutralized, the dangling bonds cannot reappear, even with photo annealing.

Subsequently, the semiconductor thus measured was taken out of the apparatus of Fig. 1 and was subjected to further measurements in the same manner as described above but with the semiconductor exposed to the atmosphere and no Staebler-Wronski effect was demonstrated (30-8, and 30'-8). Consequently, it was proved that the method and apparatus of the present invention enables very stable semiconductor devices to be manufactured.

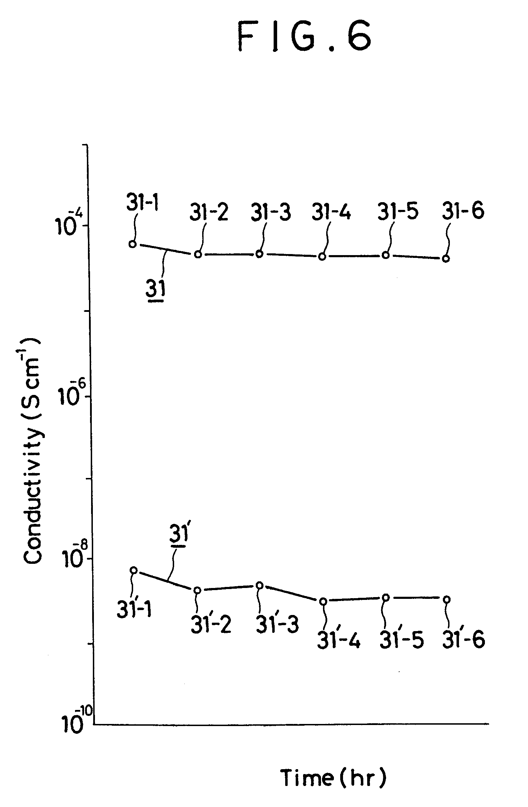

Fig. 6 shows another example of the conductivity variations of a semiconductor fabricated by the method of the invention with dangling bonds neutralized by a neutralizer agent. In this example, before measurement the semiconductor was irradiated with light for 48 hours, or at least more than 3 hours so that a sufficient number of dangling bonds appeared, and highly purified fluorine gas was introduced into the pre-stage chamber in order to neutralize the dangling bonds according to the formula

2Si- + F₂ → 2SiF

The Si-F binding is expected to be stable even in atmospheric air. The electronegativity of fluorine is 4.0 while the electronegativity of oxide is 3.5. Photo and thermal annealings were repeatedly carried out under the same condition as described above with reference to Fig. 3. As may be seen from Fig. 6, the conductivity did not fluctuate substantially. From this experiment it may be deduced that few recombination centers reappear on the semiconductor.

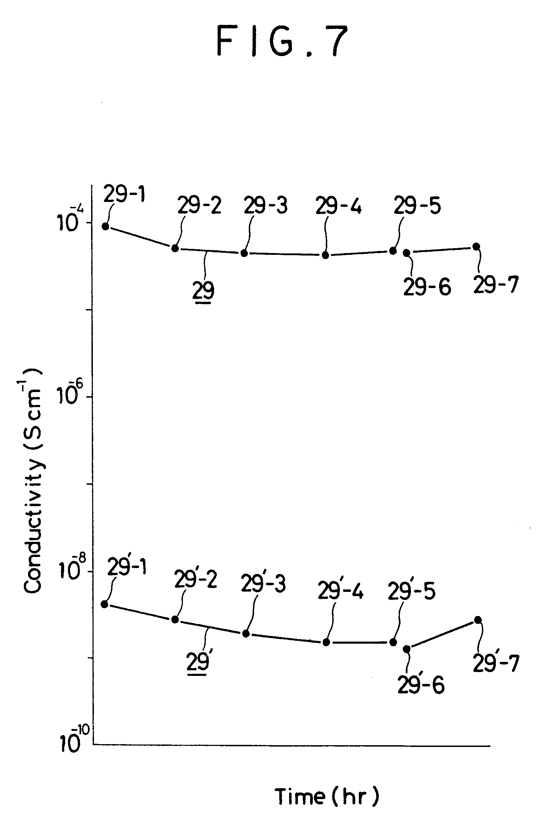

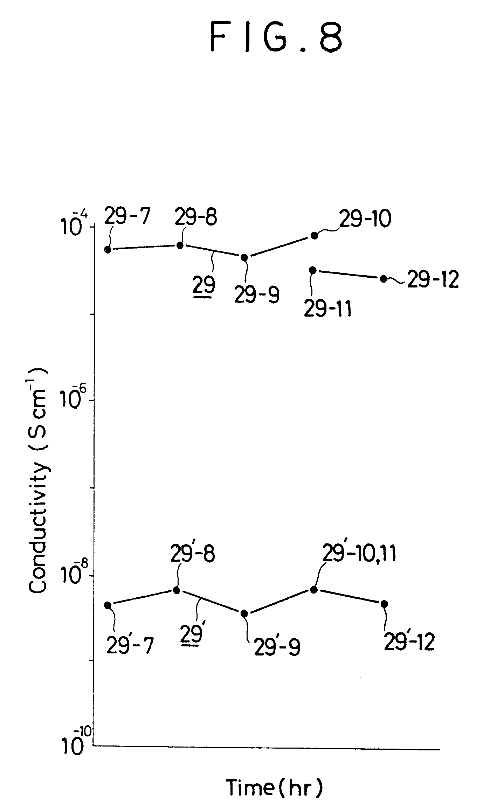

Referring to Fig. 7, the conductivity variations of a further embodiment are shown. In this example, measured results 29-1 to 29-5, and 29'-1 to 29'-5 are obtained under the same conditions and using the same kind of specimen as described with reference to Fig. 4. After the initial measurements 29-5 and 29'-5 were made, argon gas was introduced into the pre-stage chamber where it connected to the dangling bonds residing on the microstructure of the semiconductor surface. Then, as described above, the SEL effect was observed at atmospheric pressure and at low pressure (1.3 Pa to 1.3 x 10⁻⁴ Pa (10⁻² to 10⁻⁶ torr)). Thereafter, the semiconductor was treated by thermal annealing at 100 to 500^{o}C in an atmosphere of argon excited by ultraviolet light. The conductivity of the semiconductor thus treated is shown by 29-6 and 29'-6. Thereafter photo and thermal annealings were repeatedly and alternately carried out as in the foregoing embodiments and the results shown in Fig. 8 indicate that conductivity fluctuations due to the Staebler-Wronski effect are largely limited as compared with the prior art.

Krypton, xenon, helium, hydrogen and mixtures of two or more thereof can effectively be used instead of argon and, in addition, the existence of a trace quantity of natrium is very advantageous for stabilizing the conductivity characteristics of the semiconductor.

The recombination center density in a semiconductor manufactured according to the present invention is estimated to be less than about 1 x 10¹⁷ to 1 x 10¹⁸ cm⁻³, and in some cases less than 5 x 10¹⁶ cm⁻³.

Though the invention has been described with respect to specific preferred embodiments thereof, many variations and modifications can be applied, for example as follows.

The neutralization process can be carried out in another chamber separate from the manufacturing device of Fig. 1.

After irradiation, the semiconductor can be thermally processed at 100 to 500^{o}C, and more desirably 250 to 300^{o}C, at ambient pressure in an atmosphere of a fluorine mixture made active by ultraviolet light irradiation. For a semiconductor thus processed, almost the same characteristics as are shown in Fig. 6 were observed.

The present invention is also applicable to the fabrication of semiconductor layers by a photo CVD method.

Besides amorphous silicon, SiₓC₁₋ₓ, (0 < X <1), SiₓSn_{1-X} (0 < X < 1), SiₓGe_{1-X} (0 < X < 1), in which hydrogen and/or fluorine is doped, or amorphous silicon fluoride or other non-monocrystalline semiconductors can be applied to the practice of the invention.

As the neutralizer agent, fluorides such as HF, CFH₃, CH₂F₂, CF₄, GeF₄, Si₂F₆ and so on, and chlorides such as HCl, CHCl₃, CH₂Cl₂, CCl₂F₂ and so on can be employed with ultraviolet light irradiation. Also oxides can be used in co-operation with ultraviolet light which decomposes the oxide into atoms.

As will be readily understood, the additives utilized in the practice of the invention as neutralizers are utilized in an entirely different manner from the way they are used in the prior art, for example as described in United States Patent No. 4,226,898 in which additives are introduced simultaneously with the fabrication process of a semiconductor carried out in an atmosphere of a reactive gas including impurities.

## Claims

1. A process for the fabrication of non-monocrystalline semiconductor material wherein the just-formed material is photoirradiated thereby to develop dangling bonds and subsequently the dangling bonds are stabilized by combination with a neutralizing agent.

2. A process a claimed in claim 1, wherein the photoirradiation is performed in an evacuated environment.

3. A process as claimed in claim 2, wherein said evacuated environment is at a pressure of less than 0.13 Pa (10⁻³ torr).

4. A process as claimed in any preceding claim, wherein the just-formed semiconductor material is maintained at a low temperature such that it does not experience thermal annealing.

5. A process as claimed in claim 4, wherein the temperature is less than 50°C.

6. A process as claimed in any preceding claim, wherein said neutralizing agent comprises a halogen, an inert gas, oxygen or nitrogen, or a mixture of two or more thereof.

7. A process as claimed in any one of claims 1 to 5, wherein the semiconductor material is deposited by a CVD process and the neutralizing agent comprises one or more of fluorine, chlorine, oxygen, nitrogen, argon, krypton, xenon, helium and hydrogen.

8. An apparatus for manufacturing semiconductor material by a process as claimed in any preceding claim, said apparatus comprising: a reaction chamber (11) in which a semiconductor layer can be formed on a substrate (10); a first pre-stage chamber (1); a transportation mechanism (19,19') for transporting the substrate between the reaction chamber and the pre-stage chamber; a vacuum pump (6,8,9) for evacuating the chambers; means for irradiating the interior of the evacuated pre-stage chamber; and a doping system (25) for subsequently introducing a neutralizing agent into the pre-stage chamber.

9. An apparatus as claimed in claim 8, further comprising a second pre-stage chamber (2) through which the substrate (10) can be transported between the first pre-stage chamber (1) and the reaction chamber (11).

10. A non-monocrystalline semiconductor device fabricated by a process in accordance with any one of claims 1 to 7, wherein the density of oxygen in the semiconductor is less than 5 x 10¹⁸ cm⁻³.

11. A non-monocrystalline semiconductor device fabricated by a process in accordance with any one of claims 1 to 7, or as claimed in claim 10, wherein the recombination center density that appears in response to light irradiation is less than 1 x 10¹⁸ cm⁻³.

## Patentansprüche

1. Verfahren zum Herstellen eines nichteinkristallinen Halbleitermaterials, bei dem das gerade hergestellte Material mit Licht bestrahlt wird, um nichtgepaarte Bindungen zu erzeugen, und anschließend die nichtgepaarten Bindungen durch Kombination mit einem Neutralisiermittel stabilisiert werden.

2. Verfahren nach Anspruch 1, bei dem die Bestrahlung mit Licht in Vakuumumgebung ausgeführt wird.

3. Verfahren nach Anspruch 2, bei dem sich die Vakuumumgebung auf einem Druck unter 0,13 Pa (10⁻³ Torr) befindet.

4. Verfahren nach einem der vorstehenden Ansprüche, bei dem das gerade hergestellte Halbleitermaterial auf so niedriger Temperatur gehalten wird, daß es keinen thermischen Tempervorgang erfährt.

5. Verfahren nach Anspruch 4, bei dem die Temperatur kleine als 50°C ist.

6. Verfahren nach einem der vorstehenden Ansprüche, bei dem das Neutralisiermittel ein Halogen, ein Inertgas, Sauerstoff oder Stickstoff oder eine Mischung von zwei oder mehreren dieser Substanzen aufweist.

7. Verfahren nach einem der Ansprüche 1 bis 5, bei dem das Halbleitermaterial durch einen CVD-Prozeß abgeschieden wird und das Neutralisierungsmittel Fluor, Chlor, Sauerstoff, Stickstoff, Argon, Krypton, Xenon, Helium oder Wasserstoff oder mehrere dieser Substanzen aufweist.

8. Vorrichtung zum Herstellen eines Halbleitermaterials durch ein Verfahren wie in einem der vorstehenden Ansprüche beansprucht, welche Vorrichtung folgendes aufweist: eine Reaktionskammer (11), in der eine Halbleiterschicht auf einem Substrat (10) ausgebildet werden kann; eine erste Vorstufenkammer (1); einen Transportmechanismus (19, 19') zum Transportieren des Substrats zwischen der Reaktionskammer und der Vorstufenkammer; eine Vakuumpumpe (6, 8, 9) zum Evakuieren der Kammer; eine Einrichtung zum Ausleuchten des Innenraums der evakuierten Vorstufenkammer; und ein Dotiersystem (25) zum anschließenden Einleiten eines Neutralisierungsmittels in die Vorstufenkammer.

9. Vorrichtung nach Anspruch 1, die ferner eine zweite Vorstufenkammer (2) aufweist, durch die das Substrat (10) zwischen der ersten Transportkammer (1) und der Reaktionskammer (11) transportiert werden kann.

10. Nichteinkristallines Halbleiterbauelement, das nach einem Verfahren gemäß einem der Ansprüche 1 bis 7 hergestellt wurde, bei dem die Dichte von Sauerstoff im Halbleiter kleiner als 5 x 10¹⁸ cm⁻³ ist.

11. Nichteinkristallines Halbleiterbauelement, das durch ein Verfahren gemäß einem der Ansprüche 1 bis 7 oder wie in Anspruch 10 beansprucht hergestellt wurde, bei dem die Dichte an Rekombinationszentren, die auf Lichtbestrahlung hin auftreten kleiner als 1 x 10¹⁸ cm⁻³ ist.

## Revendications

1. Procédé pour la fabrication de matière semi-conductrice non monocristalline, dans lequel la matière, qui vient juste d'être formée, est photo-irradiée pour ainsi donner lieu à des liaisons instables, les liaisons instables étant ensuite stabilisées par combinaison avec un agent neutralisant.

2. Procédé selon la revendication 1, dans lequel la photo-irradiation est effectuée dans un environnement sous vide.

3. Procédé selon la revendication 2, dans lequel ledit environnement sous vide est à une pression inférieure à 0,13 Pa (10⁻³ torr).

4. Procédé selon l'une des revendications précédentes, dans lequel la matière semi-conductrice, qui vient juste d'être formée, est maintenue à une basse température de manière à ne pas subir de recuit thermique.

5. Procédé selon la revendication 4, dans lequel la température est inférieure à 50° C.

6. Procédé selon l'une des revendications précédentes, dans lequel ledit agent neutralisant comprend un halogène, un gaz inerte, de l'oxygène ou de l'azote, ou un mélange de deux ou plus de ceux-ci.

7. Procédé selon l'une quelconque des revendications 1 à 5, dans lequel la matière semi-conductrice est déposée par un procédé de dépôt chimique en phase vapeur, et dans lequel l'agent neutralisant comprend un ou plusieurs parmi le fluor, le chlore, l'oxygène, l'azote, l'argon, le krypton, le xénon, l'hélium et l'hydrogène.

8. Appareil pour la fabrication de matière semi-conductrice par un procédé selon l'une quelconque des revendications précédentes, ledit appareil comprenant : une chambre de réaction (11) dans laquelle une couche semi-conductrice peut être formée sur un substrat (10) ; une première chambre préliminaire (1) ; un mécanisme d'acheminement (19, 19') pour acheminer le substrat entre la chambre de réaction et la chambre préliminaire ; une pompe à vide (6, 8, 9) pour faire le vide dans les chambres ; un moyen pour irradier l'intérieur de la chambre préliminaire sous vide ; et un système de dopage (25) pour introduire ensuite un agent neutralisant dans la chambre préliminaire.

9. Appareil selon la revendication 8, comprenant en outre une deuxième chambre préliminaire (2) dans laquelle le substrat (10) peut être acheminé entre la première chambre préliminaire (1) et la chambre de réaction (11).

10. Dispositif semi-conducteur non monocristallin fabriqué par un procédé selon l'une quelconque des revendications 1 à 7, dans lequel la densité d'oxygène dans le semi-conducteur est inférieure à 5 x 10¹⁸ cm⁻³.

11. Dispositif semi-conducteur non monocristallin fabriqué par un procédé selon l'une quelconque des revendications 1 à 7, ou selon la revendication 10, dans lequel la densité des centres de recombinaison, qui apparaît en réponse à l'exposition à la lumière, est inférieure à 1 x 10¹⁸ cm⁻³.
